Europäisches Patentamt

European Patent Office

Office européen des brevets

(19)

(11) Numéro de publication : **0 091 075 B1**

(12) **FASCICULE DE BREVET EUROPÉEN**

(45) Date de publication du fascicule du brevet :
07.05.86

(21) Numéro de dépôt : 83103119.0

(22) Date de dépôt : 29.03.83

(51) Int. Cl.⁴ : **H 05 K   3/00**

(54) Procédé d'élaboration de circuits d'interconnexion multicouches.

(30) Priorité : 01.04.82 FR 8205625

(43) Date de publication de la demande :
12.10.83 Bulletin 83/41

(45) Mention de la délivrance du brevet :
07.05.86 Bulletin 86/19

(84) Etats contractants désignés :
CH DE FR GB IT LI NL SE

(56) Documents cités :
US-A- 3 791 858
US-A- 3 798 762
ELECTRONICS, vol. 52, no. 20, 27 Septembre 1979,
NEW YORK (US) C.L. LASSEN: "Wanted: a new
interconnection technology", pages 113-121

(73) Titulaire : **COMPAGNIE INDUSTRIELLE DES TELE-COMMUNICATIONS CIT-ALCATEL S.A. dite:**
**12, rue de la Baume**
**F-75008 Paris (FR)**

(72) Inventeur : **Roche, Georges**
**1, Villa Suzanne**
**F-92320 Chatillon sous Bagneux (FR)**
Inventeur : **Lantaires, Jacques**
**10bis, Allée de la Tournelle**
**F-91370 Verrières le Buisson (FR)**
Inventeur : **Ritzinger, Gérard**
**15 Parc de Diane**
**F-78350 Jouy en Josas (FR)**

(74) Mandataire : **Weinmiller, Jürgen et al**
**Zeppelinstrasse 63**
**D-8000 München 80 (DE)**

## Description

La présente invention a pour objet un procédé d'élaboration de circuits d'interconnexion multicouches en particulier pour l'interconnexion de circuits intégrés à grande échelle de type LSI.

Il est usuel de chercher à obtenir des circuits d'interconnexion à haute densité de liaison, sous forme de circuits multicouches, notamment pour des circuits intégrés de type LSI. En ce but on réalise un empilage de couches de pistes conductrices séparées par des couches isolantes, sur un substrat isolant. Les pistes conductrices de couches différentes sont reliées entre elles par des traversées ménagées à travers les couches isolantes suivant les besoins ; celles de ces traversées qui sont ménagées dans l'une des couches isolantes externes permettent de relier les circuits intégrés qu'on vient y assujettir, avec les pistes de couches internes.

L'un des inconvénients présentés par les procédés de ce type est que les substrats isolants doivent posséder certaines caractéristiques pour l'élaboration des couches qui ne sont pas nécessairement compatibles avec les besoins électriques, thermiques ou mécaniques ultérieurs.

La présente invention a donc pour but un procédé d'élaboration de circuits d'interconnexion multicouches rentablement exploitable même avec de moyennes et petites séries de circuits, ce procédé permettant l'emploi de matériaux non nobles, donc moins coûteux, ainsi que la mise en œuvre de techniques peu consomma-trices en énergie.

Ce but est atteint par le procédé conforme à la revendication 1.

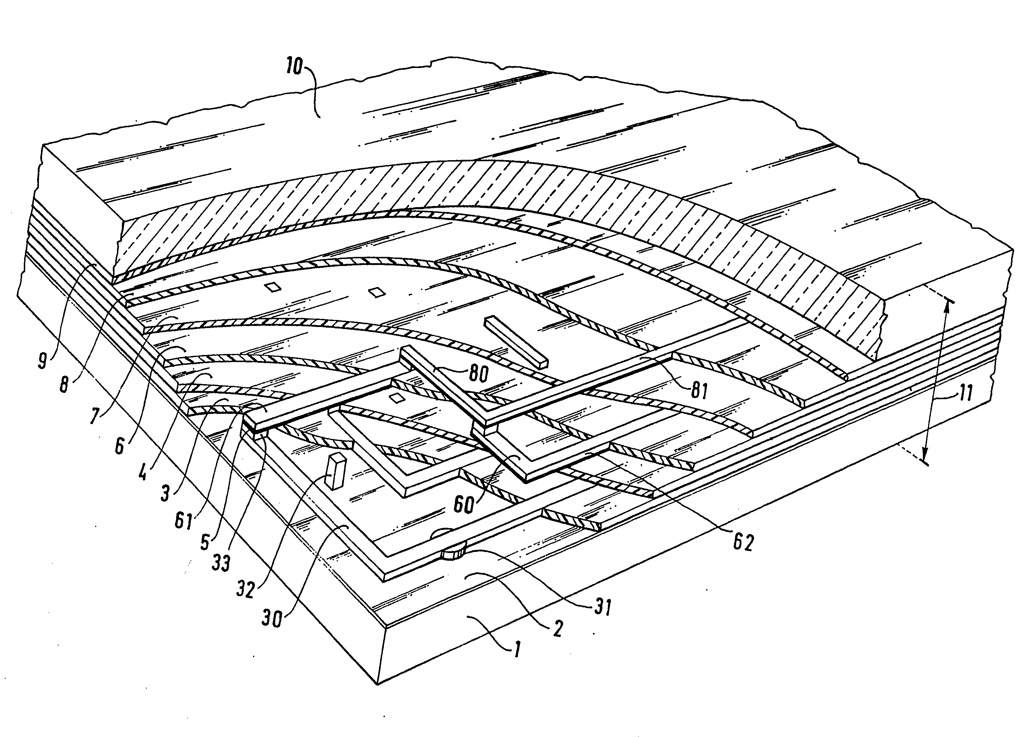

L'invention sera exposée plus en détail en liaison avec la figure unique jointe.

La figure unique présente une vue en arraché partiel d'un exemple schématique de circuit d'interconnexion réalisé par le procédé selon l'invention.

En ce but on réalise en premier lieu une mince couche 2 d'alliage à bas point de fusion sur un premier substrat 1 électriquement conducteur métallique, destiné à servir de base de croissance à un empilage de couches.

Le substrat peut par exemple être constitué d'une tôle d'acier usuelle et l'alliage est par exemple un alliage d'étain et de plomb du type de ceux qui sont classiquement utilisés pour la soudure d'interconnexion de circuits électriques.

L'épaisseur de la couche d'alliage 2 recouvrant le substrat 1 est préférablement choisie faible par exemple de l'ordre de 10 à 30 μm.

En second lieu on dépose une première couche 3 en matériau isolant, par exemple une résine, sur la couche d'alliage 2 en laissant l'alliage à nu à l'intérieur du tracé des zones destinées à rester conductrices pour former les pistes d'interconnexion, les plots de connexion avec des circuits électriques extérieurs au composant en cours de formation, ou d'éventuelles traversées intercouches débouchant à ce niveau. Le dépôt de la couche isolante est effectué par un procédé classique en ce domaine par exemple par sérigraphie ou par photolithographie.

L'épaisseur de la première couche isolante 3 est choisie égale à l'épaisseur que l'on veut donner aux pistes et plots de la couche de connexion que l'on va réaliser à la phase suivante.

En troisième lieu on effectue une métallisation des zones de la couche d'alliage 2 qui ont été laissées à nu de manière que le métal déposé viennent affleurer le niveau supérieur libre de la première couche isolante 3 précédemment formée.

La métallisation est par exemple de type électrolytique et le métal formant les pistes 30, plots 31 et embases de traversées d'interconnexion 32, 33 de la couche de connexion est par exemple du cuivre.

En quatrième lieu, on dépose une seconde couche isolante 4 ne laissant à nu que les zones correspondant aux traversées intercouches, telles 32 ou 33. L'épaisseur de résine de cette couche 4 est fonction des caractéristiques recherchées notamment en ce qui concerne l'isolement.

En cinquième lieu, on amène à nouveau par métallisation électrolytique les surfaces métalliques laissées à nu, à niveau avec la surface supérieure libre de la couche isolante 4.

En sixième lieu, on réalise une très mince couche conductrice dite d'amorçage 5 sur la surface plane composée de la seconde couche isolante 4 et des parties affleurantes des traversées intercouches. Cette couche d'amorçage 5 a un tracé correspondant à celui des zones destinées à être conductrices dans la couche immédiatement supérieure à former ultérieurement, elle est formée de manière classique par exemple par sérigraphie ou par photolithographie.

En septième lieu, on réalise une troisième couche isolante 6 en dehors des zones conductrices de la couche d'amorçage 5. L'épaisseur de cette troisième couche isolante 6, préférablement en résine, est également choisie égale à l'épaisseur que l'on veut donner aux pistes de la couche de connexion que l'on va réaliser à la phase suivante, le procédé de réalisation de cette couche isolante étant préférablement analogue à celui déjà utilisé.

En huitième lieu, on amène à niveau, par métallisation électrolytique, les zones laissées à nu de la couche d'amorçage 5 avec la surface supérieure libre de la troisième couche isolante 6, en formant ainsi les pistes conductrices d'une nouvelle couche d'interconnexion. Préférablement le métal utilisé pour la réalisation des pistes, telles 60, 61 ou 62, par électrolyse est identique à celui déjà utilisé en ce même but au cours des phases précédentes et les dimensions des pistes sont classiquement fonction des caractéristiques électriques recherchées, en particulier, en ce qui concerne l'intensité maximale admise.

Par une répétition des quatre dernières opérations évoquées ci-dessus on réalise le nombre désiré de couches supplémentaires d'interconnexion, telle la couche comportant les pistes 80, 81 noyées dans la couche isolante 8 réalisée sur la couche isolante 7 couvrant notamment les pistes 60, 61, 62 évoquées plus haut.

Lorsque la dernière couche d'interconnexion, affleurant la couche isolante qui la contient, a été réalisée, telle la couche comportant les pistes 80 et 81 affleurant la surface supérieure libre de la couche isolante 8, on dépose une nouvelle couche de résine isolante 9 recouvrant l'ensemble de la surface à l'exception d'éventuelles traversées intercouches destinées par exemple à constituer des drains thermiques, tel 32.

Puis, on colle sur cette dernière couche isolante 9 un substrat permanent 10 en un matériau choisi en fonction des besoins.

Ce substrat permanent 10 étant simplement collé peut être quelconque puisqu'il n'a pas à respecter les contraintes imposées aux substrats sur lesquels on réalise des couches.

Le substrat 10 peut donc être choisi parmi de nombreux matériaux éventuellement peu coûteux, métalliques, minéraux ou organiques, par exemple en métal bon conducteur de la chaleur, en verre, ou en céramique en fonction des contraintes électriques, thermiques ou mécaniques à satisfaire.

En dernier lieu on sépare l'empilage de couches formées sur le substrat temporaire 1 en faisant fondre la couche d'alliage 2 par chauffage de cette couche au-delà du point de fusion de l'alliage qui la compose.

Ceci met donc à jour les surfaces devenues libres des plots 31, traversées intercouches 32 et pistes 30 réalisées au cours de la troisième phase, pour permettre la mise en liaison électrique ultérieure des zones conductrices internes à l'empilage avec des circuits électriques extérieurs non figurés qu'elles ont pour objet d'interconnecter selon une organisation donnée.

De plus la fusion laisse subsister une couche d'alliage sur les surfaces conductrices affleurant la surface inférieure devenue libre de la première couche isolante 3. Ceci évite d'avoir à étamer les emplacements des connexions avec les liaisons provenant des circuits extérieurs que l'on viendra reporter sur la surface devenue libre de la première couche 3, si l'alliage fusible formant la couche 2 est convenablement choisi en appliquant les connaissances usuelles en ce domaine.

Le procédé selon l'invention permet donc de réaliser à faible prix des circuits multicouches d'interconnexion à haute densité en particulier pour circuits LSI en microboîtiers, tout en conservant une grande liberté dans le choix du substrat final.

Le faible coût est rendu possible par l'emploi de techniques peu consommatrices en énergie, telles que la métallisation électrolytique, où la cuisson à basse température et la possible mise en œuvre de matériaux non nobles, tels que le cuivre ou le nickel.

## Revendications

1. Procédé d'élaboration de circuits d'interconnexion multicouches, dans lequel on réalise un empilage de couches (11), comportant alternativement des zones conductrices d'interconnexion et des zones isolantes munies de traversées reliant les zones conductrices, sur un substrat temporaire (1) métallique recouvert d'une première couche (2) conductrice en alliage à bas point de fusion, on colle sur la dernière couche (9) de l'empilage (11) un substrat permanent (10) situé de l'autre côté de l'empilage (11) par rapport au substrat temporaire (1) et on sépare par fusion de la première couche (2) l'empilage de couches du substrat temporaire (1) en mettant ainsi à jour des zones conductrices (30, 31, 32) de l'empilage qui sont destinées à la mise en liaison des zones conductrices internes avec l'extérieur.

2. Procédé d'élaboration de circuits d'interconnexion multicouches selon la revendication 1, caractérisé en ce qu'il comporte des étapes intermédiaires suivantes :

— dépôt d'une première couche isolante sur la mince couche d'alliage à bas point de fusion (2), en dehors de zones destinées à rester conductrices, notamment pour former des pistes d'interconnexion (30), des plots de connexion (31), ou des traversées débouchantes intercouches (32, 33),

— métallisation des zones non recouvertes par l'isolant de la première couche (3) et ce jusqu'au niveau supérieur de cette couche, à l'aide d'un métal bon conducteur, pour former une couche dite de connexion,

— dépôt d'une seconde couche d'isolant (4) sur la première couche isolante (3) et sur les zones conductrices de la couche de connexion à l'exception des zones destinées aux traversées intercouches (32, 33),

— métallisation des zones non recouvertes par la seconde couche d'isolant (4) jusqu'au niveau de cette seconde couche, de manière à former les traversées intercouches (32, 33),

— dépôt d'une mince couche d'amorçage (5) bonne conductrice, sur la seconde couche d'isolant (4) et sur les traversées intercouches qui y affleurent, selon un tracé fixant les positions des zones conductrices immédiatement supérieures ultérieures,

— dépôt d'une troisième couche d'isolant (6) sur la seconde couche isolante (4) en dehors des zones conductrices définies par la couche d'amorçage (5),

— métallisation des zones conductrices définies par la couche d'amorçage jusqu'au niveau supérieur de la troisième couche isolante,

— répétition éventuelle des trois phases précédentes,

— dépôt d'une couche isolante supplémentaire (9) sur la dernière couche isolante obtenue et sur les zones métallisées qui y affleurent, à l'exception d'éventuelles traversées intercouches.

3. Procédé de réalisation selon la revendication 2, caractérisé en ce que les phases de dépôt des couches permanentes, sont obtenues par sérigraphie ou photolithographie et que les phases de métallisation sont obtenues par électrolyse.

4. Procédé de réalisation selon la revendication 1, caractérisé en ce que la phase de fusion conserve une pellicule d'alliage sur les zones conductrices extérieures (30, 31, 32, 33) de la couche de connexion pour le soudage ultérieur de composants rapportés.

## Claims

1. A method of manufacturing multilayer interconnecting circuits, according to which a stack of layers (11), comprising alternately conductive interconnection areas and insulating areas having transverse passage connecting the conductive areas, is formed on a temporary metal substrate (1) covered by a first conductive layer (2) of an alloy having a low melting point, then on the last layer (9) of the stack (11) a permanent substrate (10) is glued, which is situated on the opposite side of the stack (11) with respect to the temporary substrate (1) and then the stack of layers is separated from the temporary substrate (1) by melting of the first layer (2), thus exposing conductive areas (30, 31, 32) of the stack which are designed to connect inner conductive areas to the outside.

2. A method of manufacturing multilayer interconnecting circuits according to claim 1, characterized in that it comprises the following intermediate steps :

— to deposit a first insulating layer (2) on the thin layer of an alloy having a low melting point outside those areas which are intended to remain conductive, in particular to form interconnecting tracks (30), contact points (31) or interlayer outlet passages (32, 33),

— to metallize the areas not covered by the insulation of the first layer (3) and this up to the upper level of this layer, by means of a conductor metal, to constitute a so-called connection layer,

— to deposit a second insulating layer (4) on the first insulating layer (3) and on the conductive areas of the connection layer except for those areas which are to become interlayer passages (32, 33),

— to metallize the areas not covered by the second insulating layer (4) up to the level of this second layer, so as to form the interlayer passages (32, 33),

— to deposit a thin conductor bond layer (5) on the second insulating layer (4) and on the interlayer passages flush with same, along a design fixing the positions of the immediately following conductive areas,

— to deposit a third insulating layer (6) on the second insulating layer (4) outside the conductive areas defined by the bond layer (5),

— to metallize of the conductive areas defined by the bond layer up to the upper level of the third insulating layer,

— to optionally repeat the three preceding steps,

— to deposit of a supplementary insulating layer (9) on the last insulating layer obtained and on the metallized areas flushing therewith, with the exception of possible interlayer passages.

3. A manufacturing method according to claim 2, characterized in that the steps of depositing the permanent layers are obtained by serigraphy or photolithography and that the metal plating steps are obtained by electrolysis.

4. A manufacturing method according to claim 1, characterized in that after the melting step an alloy film remains on the outer conductive areas (30, 31, 32, 33) of the connection layer for the subsequent soldering of added components.

## Patentansprüche

1. Verfahren zur Herstellung mehrlagiger Verbindungsschaltkreise, bei dem man einen Stapel von Schichten (11) herstellt, die abwechselnd leitende Verbindungsbereiche und isolierende Bereiche mit die leitenden Bereiche verbindenden Durchgängen auf einem provisorischen metallischen Substrat (1) aufweisen, das mit einer ersten leitenden Schicht (2) aus einer Legierung mit niedrigem Schmelzpunkt bedeckt ist, bei dem man auf die letzte Schicht (9) des Stapels (11) ein endgültiges Substrat (10) aufklebt, das sich bezüglich des provisorischen Substrats auf der anderen Seite des Stapels (11) befindet, und bei dem man durch Schmelzen der ersten Schicht (2) den Schichtenstapel vom provisorischen Substrat (1) trennt, und so leitende Bereiche (30, 31, 32) des Stapels freilegt, die dazu bestimmt sind, innere leitende Bereiche nach außen zu verbinden.

2. Verfahren zur Herstellung mehrlagiger Verbindungsschaltkreise nach Anspruch 1, dadurch gekennzeichnet, daß es die folgenden Zwischenstufen aufweist :

— Aufbringen einer ersten isolierenden Schicht auf die dünne Schicht einer Legierung mit niedrigem Schmelzpunkt (2), und zwar außerhalb der Bereiche, die leitend bleiben sollen, insbesondere um Verbindungsbahnen (30), Anschlußpunkte (31) oder von außen zugängliche Durchgänge (32, 33) zwischen den Schichten zu bilden,

— Metallisierung der nicht mit der Isolierung der ersten Schicht (3) bedeckten Bereiche, und zwar bis in Höhe der Oberseite dieser Schicht, mithilfe eines gut leitenden Metalls, um eine sogenannte Verbindungsschicht zu bilden,

— Aufbringen einer zweiten Isolierschicht (4) auf die erste Isolierschicht (3) und auf die leitenden Bereiche der Verbindungsschicht mit Ausnahme der Bereiche, die für die Durchgänge (32, 33) zwischen den Schichten bestimmt sind,

— Metallisierung der nicht von der zweiten Isolierschicht (4) bedeckten Bereiche bis in Höhe dieser zweiten Schicht, um die Durchgänge (32, 33) zu bilden,

— Aufbringen einer dünnen gut leitenden Haftschicht (5) auf die zweite Isolierschicht (4) und auf die dorthin reichenden Durchgänge, gemäß einer Fläche, die die Positionen der späteren direkt darüberliegenden leitenden Bereiche bestimmt,

— Aufbringen einer dritten Isolierschicht (6) auf die zweite Isolierschicht (4) außerhalb der von der Haftschicht (5) definierten leitenden Bereiche,

— Metallisierung der von der Haftschicht definierten leitenden Bereiche bis in Höhe der Oberseite der dritten Isolierschicht,

— eventuelle Wiederholung der drei vorhergehenden Schritte,

— Aufbringen einer zusätzlichen Isolierschicht (9) auf die oberste Isolierschicht und auf die dorthin reichenden metallisierten Bereiche, mit Ausnahme eventueller Durchgänge zwischen den Schichten.

3. Herstellungsverfahren nach Anspruch 2, dadurch gekennzeichnet, daß die endgültigen Schichten durch Serigraphie oder Photolithographie aufgebracht werden und daß die Metallisierungen durch Elektrolyse aufgebracht werden.

4. Herstellungsverfahren nach Anspruch 1, dadurch gekennzeichnet, daß beim Schmelzen der ersten Schicht ein Legierungsfilm auf den äußeren leitenden Bereichen (30, 31, 32, 33) der Verbindungsschicht zum späteren Anschweißen von Bestückungsbauteilen zurückbleibt.

1